# FASCICULE DE BREVET EUROPEEN

(11) **EP 2 036 128 B1**
(45) Date de publication et mention de la délivrance du brevet: **05.05.2010**
(21) Numéro de dépôt: 07803759.5
(22) Date de dépôt: 20.06.2007
(51) Int. Cl.: H01L 27/32

(54) **DISPOSITIF D'AFFICHAGE ET UTILISATIONS DE CELUI-CI**
ANZEIGEVORRICHTUNG UND IHRE VERWENDUNG
DISPLAY DEVICE AND USES THEREOF

(30) Priorité: 30.06.2006 FR 0605955
(43) Date de publication de la demande: 18.03.2009
(73) Titulaire: Thomson Licensing, 92443 Issy-les-Moulineaux Cedex (FR)
(72) Inventeur: VAUFREY, David, F-38000 Grenoble (FR); LE ROY, Philippe, F-35830 Betton (FR); PRAT, Christophe, F-44100 Nantes (FR)
(74) Mandataire: Blot, Philippe Robert Emile
(86) Numéro de dépôt international: PCT/FR2007/001020
(87) Numéro de publication internationale: WO 2008/000933

(56) Documents cités:
- EP-A- 1 164 641
- DE-A1- 10 258 712
- JP-A- 11 354 773
- US-B1- 6 356 031
- US-B1- 6 511 187

## Description

La présente invention concerne un dispositif d'affichage comprenant au moins un élément lumineux, des moyens d'alimentation propres à alimenter en énergie électrique le ou chaque élément, la luminance du ou de chaque élément étant fonction de l'énergie électrique alimentant le ou chaque élément, et des moyens de détection de l'irradiance du rayonnement lumineux ambiant, le ou chaque élément étant apte à être alimenté par une énergie électrique propre à varier en fonction de l'irradiance du rayonnement lumineux ambiant.

Il est connu un dispositif d'affichage comprenant des émetteurs de lumière alimentés par des batteries, une photodiode propre à détecter l'irradiance du rayonnement lumineux ambiant et des moyens de commande aptes à commander les batteries afin d'augmenter l'énergie électrique alimentant les émetteurs lorsque l'irradiance du rayonnement ambiant est supérieure à une valeur prédéfinie.

Un dispositif antérieur est connu des documents US 6 028 327, US 2005/0260777, US 6 356 031, US 6 511 187, DE 102 58 712 et JP 11 354 773.

Un tel dispositif d'affichage permet d'ajuster le niveau de luminance de l'écran en fonction de l'irradiance de la lumière ambiante.

Toutefois, ce dispositif d'affichage consomme plus d'énergie électrique qu'un dispositif d'affichage classique car les émetteurs consomment davantage d'énergie électrique lorsque la luminance de l'écran est augmentée. En conséquence, il est nécessaire de recharger les batteries régulièrement. Or, après un certain nombre de rechargements, les batteries ne sont plus utilisables et doivent être changées.

L'invention a pour but de proposer un dispositif d'affichage alternatif qui consomme moins d'énergie électrique.

A cet effet, l'invention a pour objet un dispositif d'affichage du type décrit dans la revendication 1.

Suivant des modes particuliers de réalisation, le dispositif d'affichage comporte l'une ou plusieurs des caractéristiques suivantes :
- les moyens propres à court-circuiter les moyens d'alimentation comprennent une diode présentant une anode et une cathode, ladite anode étant connectée aux moyens d'alimentation ;
- les moyens de détection comprennent au moins une cellule photovoltaïque ;
- les moyens de détection comprennent pour chaque élément lumineux, au moins une cellule photovoltaïque propre à alimenter un unique émetteur ; et
- chaque élément lumineux est un élément lumineux d'un dispositif d'affichage de type OLED ou un élément lumineux d'un écran LCD.

L'invention a également pour objet un feu de circulation comportant un dispositif d'affichage selon l'une quelconque des caractéristiques mentionnées ci-dessus.

L'invention a également pour objet un ordinateur comportant un dispositif d'affichage selon l'une quelconque des caractéristiques mentionnées ci-dessus.

L'invention sera mieux comprise à la lecture de la description qui va suivre, donnée uniquement à titre d'exemple, et faite en se référant aux dessins, sur lesquels :
- la figure 1 est une vue schématique d'un dispositif d'affichage selon un premier mode de réalisation de l'invention ;
- la figure 2 est une vue schématique d'une cellule photovoltaïque utilisée dans le dispositif d'affichage selon le premier mode de réalisation de l'invention ;

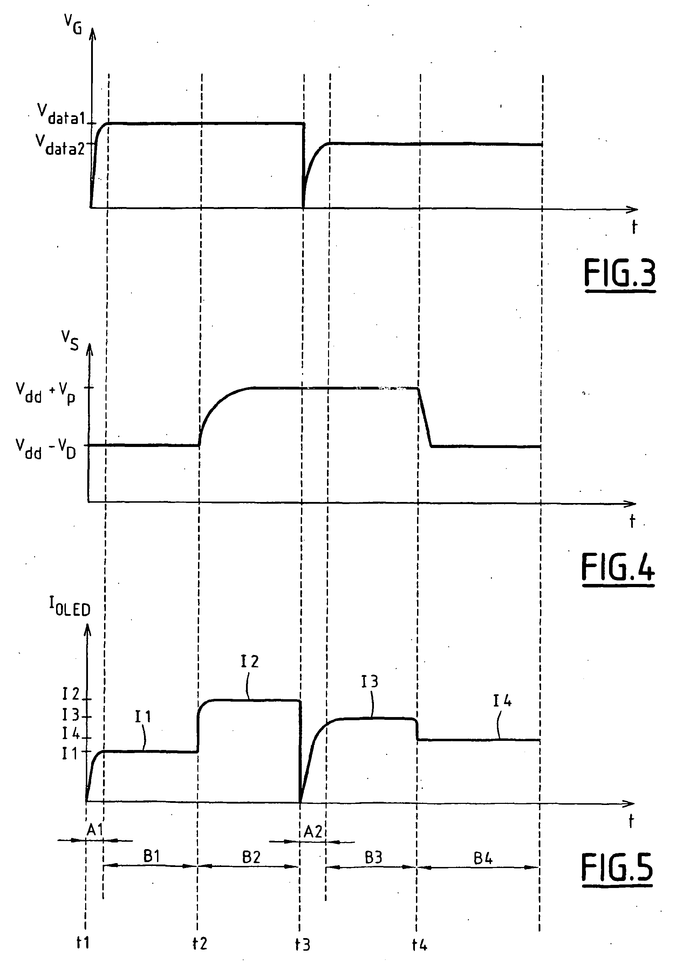

- les figures 3 à 5 sont des graphes représentant l'évolution au cours du temps de la tension à la grille et à la source d'un modulateur ainsi que de l'intensité traversant un émetteur du dispositif d'affichage illustré sur la figure 1 ; et
- la figure 6 est une vue schématique d'un dispositif d'affichage selon un second mode de réalisation de l'invention.

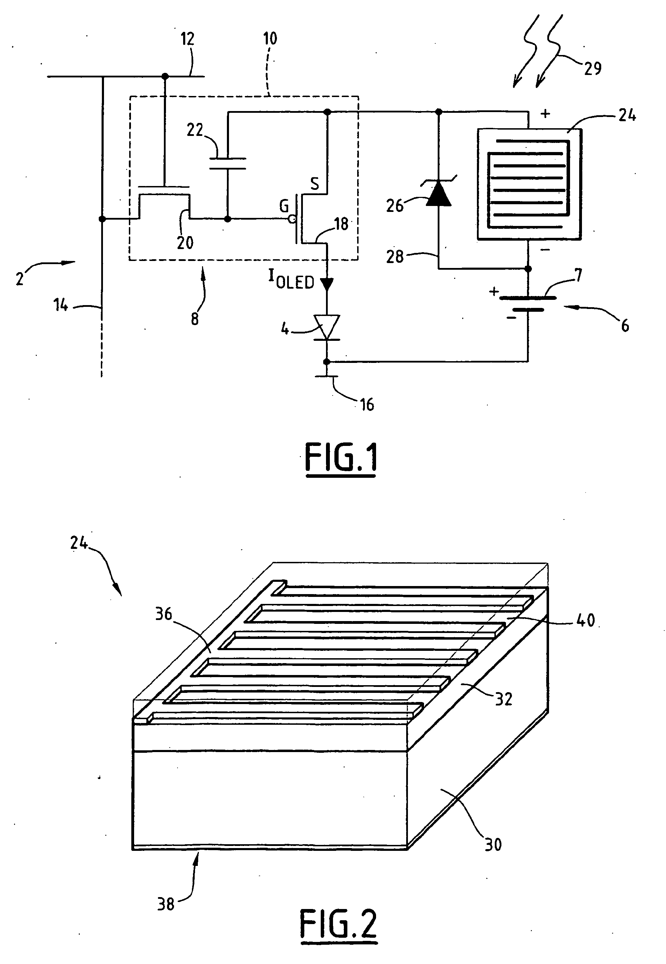

La figure 1 représente un dispositif d'affichage 2 selon un premier mode de réalisation de l'invention.

Un tel dispositif d'affichage est dit à matrice active. Il comprend une pluralité d'émetteurs 4 de lumière formant un réseau de lignes et de colonnes, des moyens d'alimentation 6 des émetteurs et des moyens de commande 8 de l'émission des émetteurs. Par souci de simplification, un seul émetteur 4, un seul moyen d'alimentation 6 et une partie des moyens de commande 8 ont été représentés sur la figure 1.

Les émetteurs 4 du dispositif d'affichage sont des diodes électroluminescentes organiques connues généralement sous l'acronyme OLED. Ils comprennent une anode et une cathode. Ils sont chacun associés à un pixel lorsque le dispositif d'affichage est monochrome ou à un sous pixel lorsque le dispositif d'affichage est polychrome. Ils sont propres à émettre une intensité lumineuse directement proportionnelle au courant qui les traverse.

Les moyens d'alimentation 6 des émetteurs comprennent un générateur 7 de tension continue tel que par exemple une batterie, apte à délivrer une tension électrique V_{dd}.

Les moyens de commande 8 du dispositif d'affichage comprennent un circuit d'adressage 10 pour chaque émetteur, un réseau d'électrodes comprenant des électrodes de sélection de lignes 12 et des électrodes d'adressage de colonnes 14.

Le circuit d'adressage 10 est connecté à chaque émetteur 4 du dispositif d'affichage. Dans ce circuit, l'anode de l'émetteur 4 forme l'interface avec la matrice active et la cathode de l'émetteur 4 est connectée à une électrode de masse 16 ou à une tension négative.

Le circuit d'adressage 10 comprend un modulateur de courant 18, un interrupteur 20 et une capacité de stockage 22.

Le modulateur de courant 18 est un transistor à couches minces basé sur une technologie utilisant du silicium poly-cristallin (poly-Si) ou du silicium amorphe (a-Si) ou du silicium monocristallin ou microcristallin ou sur une technologie organique déposé en couche mince sur un substrat de verre. De tels composants comprennent trois électrodes : une électrode de drain et une électrode de source S entre lesquelles circule un courant de drain modulé, et une électrode de grille G à laquelle est appliquée une tension de donnée V_{data1}.

Les transistors à couches minces TFT (Thin Film Transistor) sont de type N ou P. Le modulateur 18 représenté sur la figure 1 est de type P. Sa source S est connectée indirectement aux moyens d'alimentation 6 et son drain est relié directement à l'anode de l'émetteur 4, de sorte qu'en fonctionnement, le courant de drain modulé circule entre sa source et son drain.

L'interrupteur 20 est également un transistor basé sur la technologie utilisant du silicium poly-cristallin (poly-Si) ou du silicium amorphe (a-Si) ou du silicium monocristallin ou microcristallin ou sur une technologie organique déposé en couche mince. L'une de ces électrodes (drain ou source) est reliée à l'électrode d'adressage 14 et l'autre électrode (drain ou source) est reliée à la grille du modulateur 18. Sa grille est connectée à l'électrode de sélection 12.

La capacité de stockage 22 est connectée entre la grille et la source du modulateur 18 pour maintenir une tension constante sur la grille du modulateur 18 et pour maintenir ainsi la brillance de l'émetteur 4 pendant une durée de trame d'image.

Le réseau d'électrodes de sélection 12 et d'adressage 14 permet de sélectionner et d'adresser un émetteur spécifique 4 parmi l'ensemble des émetteurs du dispositif d'affichage.

Chaque électrode de sélection 12 est reliée à la grille des interrupteurs 20 d'une ligne et est apte à transmettre une tension de sélection V_{select} à l'ensemble des émetteurs 4 de cette ligne pour ouvrir les interrupteurs 20. La tension de sélection V_{select} est une donnée logique de sélection des émetteurs.

Chaque électrode d'adressage 14 est reliée à la source ou au drain des interrupteurs 20 d'une colonne et est apte à adresser une tension de donnée V_{data1} à l'une des électrodes (drain ou source) des interrupteurs 20 de cette colonne.

L'intensité du courant passant dans l'émetteur 4 est proportionnelle à l'amplitude de la tension de donnée V_{data1} qui est appliquée à l'électrode d'adressage 14.

Le dispositif d'affichage 2 comprend en outre une cellule photovoltaïque 24 connectée en série aux moyens d'alimentation 6 et une diode de Schottky 26 reliée sur une branche 28, en parallèle à la cellule photovoltaïque 24.

La cellule photovoltaïque 24 est apte à détecter et à capter le rayonnement lumineux ambiant 29, à le convertir en énergie électrique pour alimenter l'émetteur 4.

Ainsi, la cellule photovoltaïque 24 est propre à détecter l'irradiance du rayonnement lumineux ambiant et à alimenter l'émetteur 4 à l'aide de l'énergie lumineuse 29 captée.

Le rayonnement ambiant 29 est soit un rayonnement solaire soit un rayonnement issu d'une autre source lumineuse, telle que par exemple une lampe.

Lorsque le dispositif d'affichage selon l'invention équipe un ordinateur ou un téléphone, la source lumineuse est de préférence indépendante de celui-ci.

Selon le mode de réalisation illustré sur la figure 2, la cellule photovoltaïque 24 comprend une couche 30 de matériau semi-conducteur de type P et une couche 32 de matériau semi-conducteur de type N déposée sur la couche 30.

La cellule photovoltaïque 24 comprend en outre des contacts électriques 36 et 38 disposés de part et d'autre des couches 30 et 32 et un film 40 anti-réflexion disposé sur le contact 36.

Le contact électrique 36 correspond à la borne négative de la cellule photovoltaïque 24 et est relié au générateur de tension 7. Le contact électrique 38 correspond à la borne positive de la cellule photovoltaïque 24 et est relié à la source du modulateur 18.

Les contacts 36 et 38 sont aptes à prélever le courant électrique induit par le transport de charges électriques entre la couche 30 de matériau semi-conducteur de type P et la couche 32 de matériau semi-conducteur de type N. En effet, lors de la réception des photons du rayonnement lumineux 29, les charges électriques et les trous des semi-conducteurs de type N et de type P se déplacent pour créer un courant électrique entre les contacts 36 et 38.

Lorsque le matériau semi-conducteur des couches 30 et 32 est constitué de silicium, la tension générée par la cellule photovoltaïque 24 est par exemple comprise entre 0,45 et 0,5 V.

La tension entre les contacts 36 et 38 de la cellule photovoltaïque 24 est relativement indépendante de l'irradiance du rayonnement lumineux intercepté par la surface de réception de la cellule. Le courant induit entre les contacts 36 et 38 est par contre apte à augmenter significativement avec l'accroissement de l'irradiance des rayonnements captés.

Une cellule photovoltaïque qui présente une surface de 100 cm² est par exemple propre à générer un courant d'environ 2,2 A, 1,4 A et 0,4 A et une tension d'environ 0,5 V quant elle est soumise à un rayonnement lumineux d'irradiance de 1000 W m⁻² s⁻¹, de 600 W m⁻² s⁻¹ et respectivement de 200 W m⁻² s⁻¹.

La branche 28 et la diode 26 constituent des moyens autorisant le passage du courant uniquement de la cathode du générateur 7 à la source du modulateur 18.

Selon le mode de réalisation décrit, la diode de Schottky 26 présente un seuil de déclenchement V_{D} par exemple égal à 0,2 V.

L'anode de la diode de Schottky 26 est connectée à la borne positive des moyens d'alimentation. La cathode de la diode de Schottky est reliée à la source du modulateur 18 de sorte que, lorsque la cellule photovoltaïque n'est pas éclairée, le courant issu des moyens d'alimentation 6 est propre à traverser la diode de Schottky 26 pour alimenter l'émetteur 4 via le modulateur 18.

En variante, plusieurs cellules photovoltaïques 24 sont connectées en série et reliées à la source du modulateur 18 et à la borne positive des moyens d'alimentation 6 pour augmenter la tension d'alimentation de l'émetteur 4.

En variante, plusieurs cellules photovoltaïques 24 sont connectées en parallèle et reliées à la source du modulateur 18 et à la borne positive des moyens d'alimentation 6 pour augmenter le courant d'alimentation de l'émetteur 4.

En fonctionnement, à l'instant t1, le dispositif d'affichage 2 est disposé dans un environnement peu lumineux, tel que par exemple à l'intérieur d'un bureau ou dans un moyen de transport souterrain.

Dans cette demande de brevet, il est considéré qu'un environnement peu lumineux correspond à un environnement dans lequel l'irradiance est inférieure à 100 W m⁻² et qu'un environnement lumineux correspond à un environnement dans lequel l'irradiance est supérieure à 100 W m⁻².

Un potentiel V_{dd} correspondant à la tension d'alimentation des moyens d'alimentation 6 est appliqué à la source du modulateur 18.

Au cours d'une étape d'initialisation A1, une tension V_{select} est appliquée à l'électrode de sélection de ligne 12. Parallèlement, une tension de donnée V_{data1} est appliquée à l'électrode d'adressage de colonnes 14. L'interrupteur 20 relié à la fois à l'électrode de sélection de lignes 12 sélectionnée et à l'électrode d'adressage de colonnes 14 adressée s'ouvre.

Le potentiel à la grille du modulateur 18 et à la borne de la capacité devient égal à V_{data1}.

Lorsque la différence de potentiel entre la grille et la source du modulateur 18 est supérieure à la tension de seuil de déclenchement du modulateur 18, un courant de drain I_{OLED}. s'établit entre le drain et la source du modulateur 18. Il traverse l'émetteur 4 qui s'illumine au cours d'une étape d'illumination B1. La différence de potentiel entre la grille et la source du modulateur 18 est égale à V_{dd} - V_{D} - V_{data1}. Le courant de drain traversant l'émetteur I_{OLED} est égal à I1.

Lorsque le dispositif d'affichage est disposé dans un environnement peu lumineux, la branche 28 et la diode 26 permettent de court-circuiter la cellule photovoltaïque 24, cette dernière se comportant comme un circuit ouvert.

A l'instant t2, le dispositif d'affichage 2 est disposé dans un environnement plus lumineux tel que par exemple à l'extérieur ou dans une pièce fortement éclairée.

La cellule photovoltaïque 24 capte le rayonnement lumineux 29 et fournit une tension Vp qui se stabilise par exemple à 0,5 V après une phase transitoire.

Lorsque le dispositif d'affichage est disposé dans un environnement lumineux, la diode 26 se comporte comme une charge afin que la tension fournie par le générateur 7 et la tension fournie par la cellule photovoltaïque 24 s'additionnent.

Comme la cellule photovoltaïque 24 est connectée en série aux moyens d'alimentation 6, un potentiel égal à V_{dd} + Vp est appliqué à la source du modulateur 18. La différence de potentiel entre la grille et la source du modulateur 18 est alors égale à V_{dd} + Vₚ - V_{data1}.

Le courant de drain I_{OLED} traversant l'émetteur 4 est égal à I2 au cours d'une étape d'illumination B2. Comme l'intensité du courant de drain I_{OLED} varie proportionnellement à l'accroissement de la différence de potentiel entre la grille et la source du modulateur 18, le courant de drain I2 traversant l'émetteur 4 présente une intensité supérieure à l'intensité du courant de drain I1 généré au cours de l'étape B1 pour la même tension de donnée V_{data1}.

Au cours d'une étape d'initialisation A2 d'une nouvelle trame d'image, au moment t3, une tension de donnée V_{data2} inférieure à la tension de donnée V_{data1} est appliquée à l'électrode d'adressage 14. Parallèlement, une tension de sélection V_{select} est appliquée à la grille du modulateur 18. L'interrupteur 20 est ouvert de sorte que la tension à la grille du modulateur 18 et à la borne de la capacité 22 est égale à V_{data2}.

Comme la cellule photoélectrique 24 est toujours disposée dans un environnement lumineux, la différence de potentiel entre la grille et la source du modulateur 18 est de V_{dd}+Vₚ-V_{data2}.

Le courant de drain I_{OLED} traversant l'émetteur 4 est égal à I3, au cours d'une étape d'illumination B3. Le courant de drain I3 traversant l'émetteur 4 présente alors une intensité inférieure au courant I2 ayant traversé l'émetteur 4 au cours de l'étape B2.

Au moment t4, le dispositif d'affichage 2 est disposé dans un environnement moins lumineux. La cellule photovoltaïque 24 ne génère plus la tension d'alimentation Vp. La différence de potentiel entre la grille et la source du modulateur 18 est égale à V_{dd} - V_{D} - V_{data2}.

Le courant de drain I4 traversant l'émetteur 4 présente une intensité inférieure à l'intensité du courant de drain I3 généré au cours de l'étape B3 pour la même tension de donnée V_{data2}.

Ainsi, le niveau de luminance de l'émetteur 4 varie en fonction de l'irradiance du rayonnement capté par la cellule photovoltaïque 24.

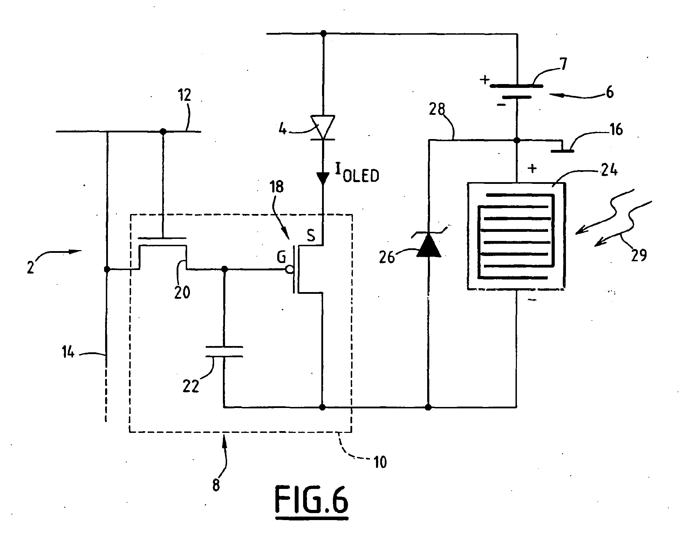

La figure 6 représente un dispositif d'affichage à matrice active selon un second mode de réalisation de l'invention.

Dans ce second mode de réalisation, le modulateur 18 utilisé dans le circuit d'adressage 10 est de type N.

Le dispositif d'affichage selon ce second mode de réalisation comprend les mêmes composants que le dispositif d'affichage selon le premier mode de réalisation. Ceux-ci ont été référencés par les mêmes références et ne seront pas décrits à nouveau.

Dans ce second mode de réalisation, la source du modulateur 18 est connectée à la cathode de l'émetteur 4. L'anode de l'émetteur 4 est reliée à la cathode du générateur 7. L'anode du générateur 7 est reliée d'une part à la cellule photovoltaïque 24 et d'autre part à la cathode de la diode de Schottky 26. La cellule photovoltaïque 24 est connectée en série au générateur 7. L'anode de la diode de Schottky 26 et un des contacts de la cellule photovoltaïque 24 sont reliés d'une part au drain du modulateur 18 et d'autre part à la capacité 22.

Lorsque la cellule photovoltaïque 24 est placée dans un environnement lumineux, le potentiel à la source du modulateur 18 varie d'une valeur sensiblement égale à la valeur de tension générée par la cellule photovoltaïque 24. La différence de potentiels entre la grille et la source du modulateur 18 augmente de façon à augmenter le courant de drain traversant l'émetteur 4 et le modulateur 18.

Selon un troisième mode de réalisation de l'invention illustré sur la figure 7, les moyens d'alimentation 6 et la cellule photovoltaïque 24 sont propres à alimenter un émetteur d'un dispositif de rétro éclairage d'un écran plasma ou d'un écran LCD.

Le dispositif d'affichage selon l'invention peut être utilisé dans un feu de circulation, dans un ordinateur, un assistant numérique personnel ou un téléphone.

La cellule photovoltaïque 24 est placée derrière l'écran OLED ou LCD.

En variante, le modulateur de courant 18 est un transistor à couches minces basés sur un substrat semi-conducteur, organique ou métallique.

En variante, la cellule photovoltaïque 24 est organique et est associée à une matrice active organique.

En variante, la diode Schottky 26 est remplacée par un semi-conducteur qui autorise le passage du courant uniquement dans un sens, tel que par exemple un transistor monté en diode ou un ensemble de deux transistors disposés tête bêche.

Avantageusement, la cellule photovoltaïque 24 est propre à détecter la présence de lumière et à alimenter l'émetteur 4 proportionnellement à l'irradiance illuminant la cellule photovoltaïque 24. Ainsi, la luminance du dispositif d'affichage 2 est ajustée automatiquement à l'éclairage ambiant. Lorsque le dispositif d'affichage est disposé par un utilisateur dans un environnement très lumineux, le dispositif d'affichage est propre à augmenter automatiquement sa luminance et son contraste afin que l'utilisateur puisse lire les données affichées sur celui-ci.

Avantageusement, la luminance de l'écran est adaptée à la luminosité ambiante sans diminuer l'autonomie électrique du dispositif d'affichage.

Avantageusement, ce dispositif d'affichage est très simple à fabriquer.

## Revendications

1. Dispositif d'affichage (2) comprenant :
- au moins un élément lumineux (4) ;
- des moyens d'alimentation (6) propres à alimenter en énergie électrique le ou chaque élément (4), la luminance du ou de chaque élément (4) étant fonction de l'énergie électrique alimentant le ou chaque élément (4) ;
- des moyens de détection (24) de l'irradiance du rayonnement lumineux ambiant (29) ; le ou chaque élément (4) étant apte à être alimenté par une énergie électrique propre à varier en fonction de l'irradiance du rayonnement lumineux ambiant (29) ; les moyens de détection (24) étant en outre aptes à capter le rayonnement lumineux ambiant (29), à le convertir en énergie électrique et à alimenter le ou chaque élément (4) avec cette énergie électrique pour augmenter le niveau de luminance de ou de chaque élément (4) en fonction de l'irradiance du rayonnement lumineux ambiant (29) ;
**caractérisé en ce que** lesdits moyens d'alimentation (6) et lesdits moyens de détection (24) sont connectés en série ; ledit dispositif comportant des moyens (26, 28) propres à court-circuiter lesdits moyens d'alimentation (6).

2. Dispositif d'affichage (2) selon la revendication 1, **caractérisé en ce que** lesdits moyens propres à court-circuiter les moyens d'alimentation (28, 26) comprennent une diode (26) présentant une anode et une cathode, ladite anode étant connectée aux moyens d'alimentation (6).

3. Dispositif d'affichage (2) selon l'une quelconque des revendications 1 et 2, **caractérisé en ce que** les moyens de détection (24) comprennent au moins une cellule photovoltaïque.

4. Dispositif d'affichage (2) selon l'une quelconque des revendications 1 à 3, **caractérisé en ce que** les moyens de détection (24) comprennent pour chaque élément lumineux, au moins une cellule photovoltaïque (24) propre à alimenter un unique émetteur (4).

5. Dispositif d'affichage (2) selon l'une quelconque des revendications 1 à 4, **caractérisé en ce que** chaque élément lumineux (4) est un élément lumineux d'un dispositif d'affichage de type OLED ou un élément lumineux d'un écran LCD.

6. Feu de circulation, **caractérisé en ce qu'**il comporte un dispositif d'affichage (2) selon l'une quelconque des revendications précédentes.

7. Ordinateur, **caractérisé en ce qu'**il comporte un dispositif d'affichage (2) selon l'une quelconque des revendications 1 à 5.

## Claims

1. Display device (2) comprising:
- at least one light-emitting element (4);
- supply means (6) capable of supplying the or each element (4) with electrical energy, the luminance of the or each element (4) being a function of the electrical energy supplied to the or each element (4);
- means (24) for detecting the irradiance of the ambient light radiation (29); the or each element (4) being arranged to be supplied with an electrical energy that is capable of being varied as a function of the irradiance of the ambient light radiation (29); the detection means (24) in addition being arranged to capture the ambient light radiation (29), to convert it into electrical energy and to supply the or each element (4) with that electrical energy in order to augment the level of luminance of the or each element (4) as a function of the irradiance of the ambient light radiation (29);
**characterised in that** said supply means (6) and said detection means (24) are connected in series; said device including means (26, 28) capable of short-circuiting said supply means (6).

2. Display device (2) according to claim 1, **characterised in that** said means (28, 26) capable of short-circuiting the supply means comprise a diode (26) having an anode and a cathode, said anode being connected to the supply means (6).

3. Display device (2) according to any one of claims 1 and 2, **characterised in that** the detection means (24) comprise at least one photovoltaic cell.

4. Display device (2) according to any one of claims 1 to 3, **characterised in that** the detection means (24) comprise, for each light-emitting element, at least one photovoltaic cell (24) capable of supplying a single emitting means (4).

5. Display device (2) according to any one of claims 1 to 4, **characterised in that** each light-emitting element (4) is a light-emitting element of an OLED-type display device or a light-emitting element of an LCD screen.

6. Traffic light, **characterised in that** it includes a display device (2) according to any one of the preceding claims.

7. Computer, **characterised in that** it includes a display device (2) according to any one of claims 1 to 5.

## Patentansprüche

1. Anzeigevorrichtung (2), folgendes umfassend:
- zumindest ein Leuchtelement (4),
- Einspeisungsmittel (6) zum Versorgen des oder jedes Elements (4) mit elektrischer Energie, wobei die Leuchtdichte des oder jedes Elements (4) abhängig ist von der das oder jedes Element (4) speisenden elektrischen Energie, und
- Detektormittel (24) für die Bestrahlungsstärke der Grundlichtstrahlung (29), wobei das oder jedes Element (4) geeignet ist, durch eine elektrische Energie gespeist zu werden, die in Abhängigkeit von der Bestrahlungsstärke der Grundlichtstrahlung variabel ist, die Detektormittel (24) außerdem geeignet sind, die Grundlichtstrahlung (29) aufzufangen, sie in elektrische Energie umzuwandeln und das oder jedes Element (4) mit dieser elektrischen Energie zu speisen, um das Niveau der Leuchtdichte des oder jedes Elements (4) in Abhängigkeit von der Bestrahlungsstärke der Grundlichtstrahlung (29) zu erhöhen,
**dadurch gekennzeichnet, dass** die Einspeisungsmittel (6) und die Detektormittel (24) in Reihe geschaltet sind und die Vorrichtung Mittel (26, 28) zum Kurzschließen der Einspeisungsmittel (6) umfasst.

2. Anzeigevorrichtung (2) nach Anspruch 1, **dadurch gekennzeichnet, dass** die Mittel zum Kurzschließen der Einspeisungsmittel (28, 26) eine Diode (26) umfassen, die eine Anode und eine Kathode aufweist, wobei die Anode mit den Einspeisungsmitteln (26) verbunden ist.

3. Anzeigevorrichtung (2) nach einem der Ansprüche 1 und 2, **dadurch gekennzeichnet, dass** die Detektormittel (24) zumindest ein Photoelement umfassen.

4. Anzeigevorrichtung (2) nach einem der Ansprüche 1 bis 3, **dadurch gekennzeichnet, dass** die Detektormittel (24) für jedes Leuchtelement zumindest ein Photoelement (24) zur Versorgung eines einzelnen Emitters (4) umfassen.

5. Anzeigevorrichtung (2) nach einem der Ansprüche 1 bis 4, **dadurch gekennzeichnet, dass** jedes Leuchtelement (4) ein Leuchtelement einer Anzeigevorrichtung des Typs OLED oder ein Leuchtelement eines LCD-Schirms ist.

6. Lichtsignalanlage, **dadurch gekennzeichnet, dass** sie eine Anzeigevorrichtung (2) nach einem der vorhergehenden Ansprüche umfasst.

7. Rechner, **dadurch gekennzeichnet, dass** er eine Anzeigevorrichtung (2) nach einem der Ansprüche 1 bis 5 umfasst.
